# EUROPEAN PATENT APPLICATION

(11) **EP 2 075 824 A1**
(43) Date of publication of application: **01.07.2009**
(21) Application number: 07791371.3
(22) Date of filing: 26.07.2007
(51) Int. Cl.: H01L 21/304, B24B 37/00, C09K 3/14

(54) **POLISHING COMPOSITION**

(30) Priority: 28.07.2006 JP 2006206800
(71) Applicant: SHOWA DENKO K.K., Tokyo 105-8518 (JP)
(72) Inventor: SATO, Takashi, Shiojiri-shi, Nagano 399-6461 (JP); TAKAHASHI, Hiroshi, Shiojiri-shi, Nagano 399-6461 (JP); SHIMAZU, Yoshitomo, Shiojiri-shi, Nagano 399-6461 (JP); ITO, Yuji, Shiojiri-shi, Nagano 399-6461 (JP)
(74) Representative: Fischer, Heinrich
(86) International application number: PCT/JP2007/064671
(87) International publication number: WO 2008/013226

(57) **Abstract**

A polishing composition which achieves surfaces with high planarity and the reduction of corrosions in the wiring metal surface at the same time is provided.

Such compositions include
(A) an oxidizing agent;
(B) at least one acid selected from an amino acid, a carboxylic acid of no more than 8 carbon atoms, and an inorganic acid;
(C) a sulfonic acid having a concentration of 0.01 % by mass or more and having an alkyl group of 8 or more carbon atoms;
(D) a fatty acid having a concentration of 0.001 % by mass or more and having an alkyl group of 8 or more carbon atoms; and
(E) at least one compound selected from a pyridine carbonyl compound, a nonionic water-soluble polymer, 2-pyrrolidone, N-methylpyrrolidone, 1,3-dimethyl-2-imidazolidinone, gramine, adenine, N,N'-diisopropylethylenediamine, N,N'-bis(2-hydroxyethyl)ethylenediamine, N,N'-dibenzylethylenediamine, and N,N'-diphenylethylenediamine.

## Description

### TECHNICAL FIELD

The present invention relates to a polishing composition, more specifically a polishing composition suitably used for polishing a substrate surface, in particular, a metal film formed on the substrate, and also relates to a technique regarding such polishing compositions.
Priority is claimed on Japanese Patent Application No. 2006-206800, filed July 28, 2006, the content of which is incorporated herein by reference.

### BACKGROUND ART

In the field of ICs (integrated circuits) and LSI (large scale integrated circuits), studies have been conducted to achieve reductions in wiring dimensions, interconnection resistance, and the dielectric constant of interlayer insulating films in order to improve operating speeds and degrees of circuit integration. Among wiring metals, copper or copper alloy has been employed in recent years so as to prevent wiring delay.

The damascene process has been employed for the formation of such wirings using copper or copper alloy. In the damascene process, for example, trenches (recessed portions) to become wiring portions are formed in an interlayer insulating film in advance, and a thin barrier film made of tantalum or tantalum nitride is then formed on the surface of the interlayer insulating film including these trenches, followed by the deposition of copper or copper alloy on the formed thin film. Since excess copper or copper alloy is deposited on the surface of the interlayer insulating film in this process, the excess copper or copper alloy is removed by conducting a polishing process due to a chemical mechanical polishing (CMP) to planarize the surface of the interlayer insulating film. Due to this process, wirings made of copper or copper alloy can be formed which are embedded in the trenches.

Meanwhile, in the field of magnetic recording, a magnetoresistive random access memory (MRAM) is attracting attention. In the MRAM, information is recorded to a specific bit of the element array. Bit lines and word lines which are extended in the lengthwise and widthwise directions, respectively, are provided while intersecting with each other, and the writing of information is selectively conducted by using only the elements located in the region where the two types of lines intersect with each other (refer to Patent Document 1, for example).

The metal wiring used in the MRAM is formed from a conductor layer composed of aluminum, aluminum alloy, copper, or copper alloy; and a ferromagnetic layer composed of nickel-iron (Permalloy) or the like which is arranged so as to surround the conductor layer. In addition, if required, thin barrier films composed of tantalum, tantalum nitride, or the like are formed so as to sandwich the ferromagnetic layer. Since the metal wiring is formed through the damascene process, excess portions of the conductor layer, ferromagnetic layer, and barrier film are removed through the CMP process described above to provide a planarized surface.

Examples of the problems encountered when forming a metal wiring by the CMP process include the following issues (1) to (3).

### (1) Achievement of practicable polishing rate in low frictional force conditions

Due to the miniaturization of wiring dimensions in recent years, it has become important to lower the dielectric constant of interlayer insulating films in order to reduce wiring delays. However, the interlayer insulating films having a low dielectric constant tend to have lower mechanical strength compared to the interlayer insulating films made of silicon oxide that have been used conventionally. For this reason, the polishing of such films with a low dielectric constant through the CMP process needs to be conducted at a low frictional force. In addition, although the polishing through the CMP process needs to be conducted at a low polishing pressure since the above frictional force is proportional to the polishing pressure, this leads to a problem because the polishing rate generally reduces as the polishing pressure reduces.

### (2) Improvements in planarity

Due to the progress in miniaturization and high integration of circuits, the wiring structure therein has become multilayered. Accordingly, it is necessary to improve planarity in each layer in order to form a wiring pattern. In the abovementioned damascene process, the barrier film made of tantalum, tantalum nitride or the like is used as a stopper layer, and the polishing process may be stopped at the time point where this barrier film appears on the surface. However, since the polishing process does not necessarily proceed all the time at the same polishing rate, polishing is conducted for longer than necessary to remove excess portions of metal films for securing process margins (known as overpolishing). For this reason, polishing is conducted even after the barrier film appears on the surface, and thus the barrier film serving as a stopper layer is not polished. This results in a dishing phenomenon, in which a dent is formed on the wiring metal, or an erosion phenomenon, in which the thickness of the barrier films within the interconnection or the thickness of the interlayer insulating films reduces in the pattern where the wiring density is high. As a result, the surface planarity deteriorates.

### (3) Corrosion (pitting corrosion: pores made by corrosion)

Even when the layers have high planarity with little occurrence of the abovementioned dishing or erosion phenomenon, the occurrence of corrosion or pitting corrosion of the wiring metal will result in the increase of interconnection resistance. Accordingly, it is required that the layers exhibit little corrosion or pitting corrosion.

The above problems (1) to (3) are specific to the CMP process involving the damascene process in which the excess portions of wiring metal are removed while using the barrier film as a stopper layer, and the properties required for the CMP process are different from those required for the polishing processes adopted for planarizing uniform materials such as hard disk media and silicon wafers. For this reason, it is difficult to solve these problems by using the polishing compositions that are used for polishing uniform materials.

When using only an abrasive material, copper and copper alloys serving as wiring metals are difficult to polish at a satisfactory polishing rate in the actual application. For example, when the concentration of an abrasive material is enhanced in order to raise the polishing rate, numerous scratches are easily formed. Accordingly, a method has been proposed using an abrasive material in which an etchant is added in order to achieve a satisfactory polishing rate for practical application while maintaining the concentration of the abrasive material relatively low.
However, when an etchant is added, problems arise such as an increase in the extent of the dishing phenomenon due to the excessive polishing of wiring metals and the occurrence of corrosion (pitting corrosion).

Polishing compositions using an azole compound such as benzotriazole or a derivative thereof have been known as additives that are capable of preventing such corrosions (for example, refer to Patent Documents 2 to 4). Benzotriazole has been known for a long time as a compound which efficiently prevents corrosion of copper and copper alloys, and it is thought that this anti-corrosive effect is due to a specific reaction caused between the compound and the copper surface. On the other hand, benzotriazole is known to interact mainly with monovalent copper to form a polymer complex, and, as a result, form a robust film (refer to Non-patent Document 1). In addition, the properties of the formed films differ depending on the pH, and it is known that thick carpet-like films are formed in the acidic region where the pH is lower than 3.5 whereas thin elaborate films are formed from the slightly acidic region to the alkaline region where the pH is greater than 3.5. Further, benzotriazole is not only added for the sake of preventing corrosion, but sometimes added in order to adjust the polishing rate or to improve the planarity through the film formation during the action of benzotriazole (for example, refer to Patent Document 2).

However, since benzotriazole has strong anticorrosive action, there is a disadvantage in that only a small amount of benzotriazole results in the considerable decline of polishing rates. Moreover, in a relatively corrosive environment, pitting corrosion is known to occur in the grain boundaries where the copper-benzotriazole film becomes discontinuous, even when benzotriazole is present (refer to Non-patent Document 1). As described so far, benzotriazole and the derivatives thereof have strong anticorrosive action, and thus it is difficult to find an adequate composition thereof in order to ensure a satisfactory polishing rate while preventing corrosion.

Meanwhile, the addition of water-soluble polymers to abrasive materials has been proposed within the concentration where the abrasive properties are not impaired in order to further enhance the dispersibility of abrasive materials and to further improve long-term storage stability (refer to Patent Document 3).
However, in this Patent Document 3, there is no mention of working Examples where a water-soluble polymer is added, and the only description regarding the corrosion inhibition is the aforementioned addition of benzotriazole or the derivatives thereof. In addition, a metal polishing composition has been proposed in which dodecylbenzenesulfonic acid and oleic acid are mixed (refer to Patent Document 5). However, the addition of such metal polishing composition is not enough to prevent corrosion.

Meanwhile, a metal polishing composition has been proposed in which pyridinecarboxylic acid is used (refer to Patent Documents 6 to 8). According to the descriptions found in these Patent Documents 6 to 8, although pyridinecarboxylic acid is used for the improvements in planarity and scratch prevention, its corrosion inhibiting effects have not been studied.

In addition, Patent Document 8 describes that a water-based dispersing element for the first polishing process may contain a water-soluble polymer as a surfactant, if necessary. However, in Patent Document 8, there is no mention of working Examples where a water-soluble polymer is added, and the only description regarding the corrosion inhibition is the addition of benzotriazole or the derivatives thereof as a film forming agent to protect the metal surface.

Meanwhile, a composition has been proposed which contains a first surfactant and a second surfactant as essential components, and also contains pyridinecarboxylic acid (refer to Patent Document 9). Specifically, this Patent Document 9 describes dodecylbenzenesulfonic acid as the first surfactant and a combination of a nonionic surfactant and a fatty acid as the second surfactant. However, only the use of nonionic surfactants such as polyoxyethylene lauryl ether as the second surfactant is described in the working Examples therein.

Meanwhile, the use of a slurry composed of ceria and a vinylpyrrolidone/vinylimidazole copolymer for the polishing of metals such as copper has been proposed (refer to Patent Document 10). However, the slurry described in this Patent document 10 is provided for use in polishing silica films, and the document describes no working Examples of the slurry applied for polishing metal films. Thus, it is apparent that a metal film can hardly be polished by the use of such a slurry composition.
[Patent Document 1] Japanese Unexamined Patent Application, First Publication No. Hei 10-116490
[Patent Document 2] Japanese Unexamined Patent Application, First Publication No. Hei 8-83780
[Patent Document 3] Japanese Unexamined Patent Application, First Publication No. 2005-183684
[Patent Document 4] Japanese Unexamined Patent Application, First Publication No. Hei 11-21546
[Patent Document 5] Japanese Unexamined Patent Application, First Publication No. 2005-340755
[Patent Document 6] Japanese Unexamined Patent Application, First Publication No. Hei 9-55363
[Patent Document 7] Japanese Unexamined Patent Application, First Publication No. 2003-289055
[Patent Document 8] Japanese Unexamined Patent Application, First Publication No. 2005-45229
[Patent Document 9] Japanese Unexamined Patent Application, First Publication No. 2002-155268
[Patent Document 10] Japanese Unexamined Patent Application, First Publication No. 2002-134444
[Non-patent Document 1] Mechanism of Corrosion Inhibition of Benzotriazole-based Inhibitor (Japan Association of Corrosion Control, 1986)

### DISCLOSURE OF INVENTION

The present invention is made in view of the above circumstances and its object is to provide a polishing composition which is capable of achieving both highly planar surfaces and the reduction of corrosions in the wiring metal surface at the same time while securing a satisfactory polishing rate even with the low polishing pressure; a polishing method using such polishing compositions; a substrate manufacturing method; a plurality of compositions and the assemblies thereof; and a method for using such compositions or assemblies as compositions for transportation or storage.

The present invention provides the following aspects.
(1) A first aspect of the present invention is a polishing composition including the following components: (A) an oxidizing agent; (B) at least one acid selected from an amino acid, a carboxylic acid of no more than 8 carbon atoms, and an inorganic acid; (C) a sulfonic acid having a concentration of 0.01 % by mass or more and having an alkyl group of 8 or more carbon atoms; (D) a fatty acid having a concentration of 0.001 % by mass or more and having an alkyl group of 8 or more carbon atoms; and (E) at least one compound selected from a pyridine carbonyl compound, a nonionic water-soluble polymer, 2-pyrrolidone, N-methylpyrrolidone, 1,3-dimethyl-2-imidazolidinone, gramine, adenine, N,N'-diisopropylethylenediamine, N,N'-bis(2-hydroxyethyl)ethylenediamine, N,N'-dibenzylethylenediamine, and N,N'-diphenylethylenediamine.
(2) A second aspect of the present invention is the polishing composition according to the first aspect, wherein the oxidizing agent is a persulfate salt.
(3) A third aspect of the present invention is the polishing composition according to the first or the second aspect, wherein a concentration of the oxidizing agent is within the range of 0.01 to 30% by mass.
(4) A fourth aspect of the present invention is the polishing composition according to any one of the first to the third aspect, wherein the carboxylic acid of no more than 8 carbon atoms is oxalic acid.
(5) A fifth aspect of the present invention is the polishing composition according to any one of the first to the fourth aspect, wherein the sulfonic acid having an alkyl group of 8 or more carbon atoms is alkylbenzene sulfonic acid.
(6) A sixth aspect of the present invention is the polishing composition according to any one of the first to the fifth aspect, wherein the fatty acid having an alkyl group of 8 or more carbon atoms is oleic acid.
(7) A seventh aspect of the present invention is the polishing composition according to any one of the first to the sixth aspect, wherein the pyridine carbonyl compound is picolinic acid or picolinamide.
(8) An eighth aspect of the present invention is the polishing composition according to any one of the first to the seventh aspect, wherein the nonionic water-soluble polymer is at least one selected from a polyvinyl alcohol, a vinylpyrrolidone (co)polymer, an acryloylmorpholine (co)polymer, and an N-isopropylacrylamide (co)polymer.
(9) A ninth aspect of the present invention is the polishing composition according to any one of the first to the eighth aspect, wherein a molecular weight of the nonionic water-soluble polymer is within the range of 3,000 to 1,000,000.
(10) A tenth aspect of the present invention is the polishing composition according to any one of the first to the ninth aspect, wherein a concentration of a component (E) is within the range of 0.01 to 5% by mass.
(11) An eleventh aspect of the present invention is the polishing composition according to any one of the first to the tenth aspect, further including an abrasive material.
(12) A twelfth aspect of the present invention is the polishing composition according to the eleventh aspect, wherein a concentration of the abrasive material is no more than 30% by mass.
(13) A thirteenth aspect of the present invention is the polishing composition according to the eleventh or the twelfth aspect, wherein the abrasive material is colloidal silica.
(14) A fourteenth aspect of the present invention is the polishing composition according to any one of the first to the thirteenth aspect, further including a phosphate ester having an alkyl group of 8 or more carbon atoms.
(15) A fifteenth aspect of the present invention is the polishing composition according to the fourth aspect, wherein a concentration of the phosphate ester having an alkyl group of 8 or more carbon atoms is no more than 0.5% by mass.
(16) A sixteenth aspect of the present invention is the polishing composition according to any one of the first to the fifteenth aspect, further including an azole group-containing compound that has 3 or more azole groups within a molecule.
(17) A seventeenth aspect of the present invention is the polishing composition according to the sixteenth aspect, wherein a molecular weight of the azole group-containing compound is within the range of 300 to 15,000.
(18) An eighteenth aspect of the present invention is the polishing composition according to the sixteenth or the seventeenth aspect, wherein the azole group containing-compound is a polymer having an azole unit that includes a vinyl group.
(19) A nineteenth aspect of the present invention is the polishing composition according to any one of the sixteenth to the eighteenth aspect, wherein a concentration of the azole group-containing compound is within the range of 0.001 1 to 1% by mass.
(20) A twentieth aspect of the present invention is the polishing composition according to any one of the sixteenth to the nineteenth aspect, wherein a molecular weight per one azole group of the azole group-containing compound is within the range of 90 to 300.
(21) A twenty-first aspect of the present invention is the polishing composition according to any one of the first to the twentieth aspect, further including an alkali.
(22) A twenty-second aspect of the present invention is the polishing composition according to any one of the first to the fifteenth aspect, wherein the pH is within the range of 5 to 11.
(23) A twenty-third aspect of the present invention is the polishing composition according to any one of the sixteenth to the twenty-first aspect, wherein the pH is within the range of 7 to 11.
(24) A twenty-fourth aspect of the present invention is the polishing composition according to any one of the first to the twenty-third aspect, further including at least one compound selected from benzotriazole, tolyltriazole, hydroxybenzotriazole, carboxybenzotriazole, benzimidazole, tetrazole and quinaldic acid, wherein the concentration of the compound is no more than 0.5% by mass.
(25) A twenty-fifth aspect of the present invention is the polishing composition according to any one of the first to the twenty-fourth aspect, wherein the polishing composition is used for polishing a metal film embedded in a substrate having a recessed portion so as to cover the recessed portion, or for polishing a barrier metal film formed and embedded in a substrate having a recessed portion so as to cover the recessed portion.
(26) A twenty-sixth aspect of the present invention is a polishing method including a step for planarizing, with use of the polishing composition of any one of the first to the twenty-fifth aspect, a metal film embedded in a substrate having a recessed portion so as to cover the recessed portion, or a barrier metal film formed and embedded in a substrate having a recessed portion so as to cover the recessed portion.
(27) A twenty-seventh aspect of the present invention is the polishing method according to the twenty-sixth aspect, wherein the metal film embedded in a substrate having a recessed portion so as to cover the recessed portion is made of copper or a copper-containing alloy.
(28) A twenty-eighth aspect of the present invention is the polishing method according to the twenty-sixth or the twenty-seventh aspect, wherein the barrier metal film is made of tantalum or a tantalum alloy.
(29) A twenty-ninth aspect of the present invention is a method for manufacturing a substrate including a step for polishing a substrate by the polishing method of any one of the twenty-fifth to the twenty-eighty aspect.
(30) A thirtieth aspect of the present invention is a composition which becomes the polishing composition of any one of the third, the tenth, the twelfth, the fifteenth, the nineteenth and the twenty-fourth aspect when diluted with water.
(31) A thirty-first aspect of the present invention is a method for using the composition of the thirtieth aspect as a composition for transportation or storage.
(32) A thirty-second aspect of the present invention is an assembly including a plurality of compositions which forms the polishing composition of any one the first to the twenty-fifth aspect when the compositions are mixed or mixed and diluted with water.
(33) A thirty-third aspect of the present invention is A method for using the assembly of the thirty-second aspect as a composition for transportation or storage.

As described so far, according to the present invention, it is possible to provide a polishing composition which achieves surfaces with high planarity and the reduction of corrosions in the wiring metal surface at the same time while securing a satisfactory polishing rate even with the low polishing pressure. Accordingly, it will be easy to manufacture substrates with excellent planarity through a polishing method and a substrate manufacturing method which use such polishing compositions. In addition, the polishing composition of the present invention can be easily produced when needed by using a plurality of compositions or an assembly thereof, which forms such polishing compositions when the compositions are mixed, as compositions for transportation or storage.

### BRIEF DESCRIPTION OF THE DRAWINGS

FIG. 1A is a transverse cross-sectional view for explaining the formation of wiring by the damascene process.
FIG. 1B is a transverse cross-sectional view for explaining the formation of wiring by the damascene process.
FIG. 1C is a transverse cross-sectional view for explaining the formation of wiring by the damascene process.
FIG. 2 is a transverse cross-sectional view for explaining the dishing phenomenon.
FIG. 3 is a transverse cross-sectional view for explaining the erosion phenomenon.

### BEST MODE FOR CARRYING OUT THE INVENTION

Embodiments according to the present invention will be described in detail below.

### (Polishing Composition)

A polishing composition of the present invention is characterized by including the following components: (A) an oxidizing agent; (B) at least one acid selected from an amino acid, a carboxylic acid of no more than 8 carbon atoms, and an inorganic acid; (C) a sulfonic acid having a concentration of 0.01% by mass or more and having an alkyl group of 8 or more carbon atoms; (D) a fatty acid having a concentration of 0. 00 1 % by mass or more and having an alkyl group of 8 or more carbon atoms; and (E) at least one compound selected from a pyridine carbonyl compound, a nonionic water-soluble polymer, 2-pyrrolidone, N-methylpyrrolidone, 1,3-dimethyl-2-imidazolidinone, gramine, adenine, N,N'-diisopropylethylenediamine, N,N'-bis(2-hydroxyethyl)ethylenediamine, N,N'-dibenzylethylenediamine, and N,N'-diphenylethylenediamine.

Specifically, among the components contained in the polishing composition of the present invention, the aforementioned components (A) and (B) are etchants for the copper or copper alloy serving as a wiring metal and are essential components necessary for achieving a satisfactory polishing rate for the practical applications. On the other hand, the aforementioned components (C) and (D) are necessary components for inhibiting the excessive etching action imposed on the copper or copper alloy serving as a wiring metal, exerting a step-height reduction effect, and achieving a polished surface having high planarity without increasing the level of dishing phenomenon during the overpolishing process.

Although the aforementioned components (C) and (D) are capable of inhibiting a considerable level of corrosions which may dissolve most of the wiring metals even when used alone, it is not satisfactory for the corrosion inhibition as a whole resulting in the deterioration of surface planarity. Accordingly, in the polishing composition of the present invention, high surface planarity is achieved due to the combination of the aforementioned components (C) and (D). In other words, it is presumed that although the aforementioned components (C) and (D) are thought to exert their function by adsorbing onto the wiring metal surface, packing properties of the components adsorbed onto the wiring metal surface are improved when these components are combined compared to the case where these components are used alone, which results in the surface with high planarity.

The mixing ratio of the aforementioned components (C) and (D) is preferably within the range of 1:50 to 50:1, more preferably within the range of 1:30 to 30:1, and still more preferably within the range of 1:20 to 20:1. Surfaces with high planarity can be achieved when these components are used so that their mixing ratio is within the above range.

The aforementioned component (E) is added for suppressing the little corrosion occurring on the wiring metal surface which escaped the corrosion inhibition by the aforementioned components (C) and (D). Unlike benzotriazole based compounds such as benzotriazole, these compounds have little effect on the reduction of polishing rate, and also on the surface planarity since corrosion is suppressed even during the overpolishing process.

The polishing composition of the present invention is capable of achieving surfaces with high planarity and the reduction of corrosions in the wiring metal surface at the same time while securing a satisfactory polishing rate even with the low polishing pressure by combining the aforementioned components (A), (B), (C), (D), and (E).

### (Each component of polishing composition)

Each of the components contained in the polishing composition of the present invention will be described below.

### <(A) Oxidizing agent>

The oxidizing agent contained in the polishing composition of the present invention oxidizes a metal, a metal alloy or the like, thereby contributes to the enhancement of polishing rate. Examples of such oxidizing agents include oxygen, ozone, hydrogen peroxide, an alkyl peroxide such as t-butyl hydroperoxide and ethylbenzene hydroperoxide, a peracid such as peracetic acid and perbenzoic acid, a permanganate salt such as potassium permanganate, a periodate salt such as potassium periodate, a persulfate salt such as ammonium persulfate and potassium persulfate, a hypochlorite salt such as potassium hypochlorite, and a polyoxoacid. Among these oxidizing agents, hydrogen peroxide and persulfate salts are preferred in view of easy handleability.
It is preferable that the concentration of the oxidizing agent be within the range of 0.01 to 30% by mass based on the total polishing composition, more preferably within the range of 0.05 to 20% by mass, and still more preferably within the range of 0.1 to 10% by mass. When the concentration of the oxidizing agent is lower than the above range, the polishing rate may become too low, whereas when the concentration of the oxidizing agent is higher than the above range, not only the oxidizing agent becomes useless, but also the polishing rate may be reduced.

### <(B) At least one acid selected from amino acids, carboxylic acids of no more than 8 carbon atoms, and inorganic acids>

The acid contained in the polishing composition of the present invention is added as an etchant to promote the polishing and at the same time, to conduct stable polishing.
Examples of the inorganic acids include sulfuric acid, phosphoric acid, phosphonic acid, and nitric acid.
Examples of the carboxylic acids of no more than 8 carbon atoms include formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, and lactic acid, and a salt thereof.
Examples of the amino acids include glycine, alanine, β-alanine, 2-aminobutyric acid, norvaline, valine, leucine, norleucine, isoleucine, alloisoleucine, phenylalanine, proline, sarcosine, ornithine, lysine, taurine, serine, threonine, allothreonine, homoserine, tyrosine, 3,5-diiodo-tyrosine, β-(3,4-dihydroxyphenyl)-alanine, thyroxine, 4-hydroxy-proline, cysteine, methionine, ethionine, lanthionine, cystathionine, cystine, cysteic acid, aspartic acid, glutamic acid, S-(carboxymethyl)-cysteine, 4-aminobutyric acid, asparagine, glutamine, azaserine, arginine, canavanine, citrulline, δ-hydroxy-lysine, creatine, kynurenine, histidine, 1-methyl-histidine, 3-methyl-histidine, ergothioneine and tryptophan.
Among these, it is preferable to use oxalic acid since it can achieve a high polishing rate as well as high surface planarity. In addition, these acids can be used alone, or two or more thereof can be combined for use.
It is preferable that the concentration of the acid be within the range of 0.01 to 10% by mass based on the total polishing composition, more preferably within the range of 0.02 to 5% by mass, and still more preferably within the range of 0.05 to 2% by mass. When the concentration of the acid is lower than the above range, it is difficult to achieve a high polishing rate, whereas when the concentration of the acid is higher than the above range, etching of a metal, metal alloy or the like may proceed at an excessively high rate, which results in heavy surface corrosion or low surface planarity at times.

### <(C) Sulfonic acids having an alkyl group of 8 or more carbon atoms>

The sulfonic acids having an alkyl group of 8 or more carbon atoms contained in the polishing composition of the present invention contribute to the step height reduction of a wiring metal as well as corrosion inhibition. Examples of the sulfonic acids having an alkyl group of 8 or more carbon atoms include an alkylsulfonic acid such as decylsulfonic acid and dodecylsulfonic acid; an alkylbenzenesulfonic acid such as decylbezenesulfonic acid, undecylbenzenesulfonic acid, dodecylbenzenesulfonic acid, tridecylbenzenesulfonic acid, and tetradecylbenzenesulfonic acid, or a mixture thereof; and an alkyl aromatic sulfonic acid such as alkylnaphthalenesulfonic acid and a formalin condensate of alkylnaphthalenesulfonic acid. Among them, it is preferable to use dodecylbenzenesulfonic acid. In addition, it is possible to use the sulfonic acids having an alkyl group of 8 or more carbon atoms in the form of a salt such as a potassium salt and an ammonium salt. Moreover, these sulfonic acids having an alkyl group of 8 or more carbon atoms can be used alone, or two or more thereof can be combined for use.
The concentration of the sulfonic acid having an alkyl group of 8 or more carbon atoms is 0.01% by mass or more based on the total polishing composition, preferably within the range of 0.01 1 to 5% by mass, more preferably within the range of 0.05 to 1% by mass, and still more preferably within the range of 0.05 to 0.5% by mass. When the concentration of the sulfonic acid having an alkyl group of 8 or more carbon atoms is lower than the above range, the step-height reduction effect is not satisfactory resulting in the low surface planarity. On the other hand, even when the concentration of the sulfonic acid having an alkyl group of 8 or more carbon atoms is higher than 5% by mass, there is little improvement in the performance of polishing compositions, and thus it is not economically advantageous.

### <(D) Fatty acids having an alkyl group of 8 or more carbon atoms>

The fatty acids having an alkyl group of 8 or more carbon atoms contained in the polishing composition of the present invention are added in combination with the aforementioned component (C) for improving surface planarity and corrosion inhibition, and they are particularly effective in the suppression of dishing phenomenon during the overpolishing process.
Examples of the fatty acids having an alkyl group of 8 or more carbon atoms include a saturated fatty acid such as caprylic acid, pelargonic acid, capric acid, lauric acid, myristic acid, pentadecylic acid, palmitic acid, margarine acid, stearic acid, arachic acid, behenic acid, lignoceric acid, cerotic acid, montanic acid, and melissic acid; and an unsaturated fatty acid such as eicosapentaenoic acid, oleic acid, linoleic acid, and linolenic acid. Among them, it is preferable to use oleic acid, and oleic acid may be used as oleic acid alone or as a fatty acid mixture containing oleic acid of 50% by mass or more. In addition, it is possible to use the fatty acids having an alkyl group of 8 or more carbon atoms in the form of a salt such as a potassium salt and an ammonium salt. Moreover, these fatty acids having an alkyl group of 8 or more carbon atoms can be used alone, or two or more thereof can be combined for use.
The concentration of the fatty acid having an alkyl group of 8 or more carbon atoms is 0.001 % by mass or more based on the total polishing composition, preferably within the range of 0.001 to 5% by mass, more preferably within the range of 0.005 to 1% by mass, and still more preferably within the range of 0.005 to 0.5% by mass. When the concentration of the fatty acid having an alkyl group of 8 or more carbon atoms is lower than the above range, the surface roughening of a metal film cannot be prevented satisfactorily, whereas when the concentration is higher than 5% by mass, it may result in the occurrence of a residual metal film on the barrier film.

### <(E) At least one compound selected from a pyridine carbonyl compound, a nonionic water-soluble polymer, 2-pyrrolidone, N-methylpyrrolidone,

### 1,3-dimethyl-2-imidazolidinone, gramine, adenine, N,N'-diisopropylethylenediamine, N,N'-bis(2-hydroxyethyl)ethylenediamine, N,N'-dibenzylethylenediamine, and N,N'-diphenylethylenediamine>

The compound (E) contained in the polishing composition of the present invention is added for suppressing the little corrosion occurring on the wiring metal surface which escaped the corrosion inhibition by the aforementioned components (C) and (D). These compounds (E) can be used alone, or two or more thereof can be combined for use.
It is preferable that the concentration of the compound (E) be within the range of 0.01 to 5% by mass based on the total polishing composition, more preferably within the range of 0.01 to 2% by mass, and still more preferably within the range of 0.01 to 1% by mass. When the concentration of the compound (E) is lower than the above range, little corrosion inhibiting effect is achieved, whereas when the concentration of the compound (E) is higher than the above range, increase in the viscosity or the stability deterioration needs to be taken into account at times when using a polishing liquid.
It should be noted, however, that unlike benzotriazole based compounds such as benzotriazole, these compounds (E) have little effect on the reduction of polishing rate. Also, their effects on the surface planarity are small since corrosion is suppressed even during the overpolishing process. For this reason, the concentration of the compound (E) is not particularly limited.

Among the aforementioned compounds (E), examples of the pyridine carbonyl compounds include a pyridine monocarboxylic acid such as picolinic acid and nicotinic acid; a dicarboxylic acid such as 2,3-pyridine dicarboxylic acid, 2,5-pyridine dicarboxylic acid, 2,6-pyridine dicarboxylic acid, 3,4-pyridine dicarboxylic acid, 3,5-pyridine dicarboxylic acid, and 5,5'-dicarboxy-2,2'-bipyridine; and a pyridine carboxylic acid amide such as picolinamide, nicotinamide, 3,4-pyridinedicarboxamide, and 2,3-pyridinedicarboximide. Among them, it is preferable to use picolinic acid or picolinamide.

On the other hand, examples of the nonionic water-soluble polymer include a polyvinyl alcohol, a vinylpyrrolidone (co)polymer, an acryloylmorpholine (co)polymer, and an N-isopropylacrylamide (co)polymer. Any of these nonionic water-soluble polymers can be used alone, or two or more types thereof can be combined for use.
In addition, it is preferable that the molecular weight of the nonionic water-soluble polymer be within the range of 3,000 to 1,500,000 in terms of weight average molecular weight, and preferably within the range of 3,000 to 1,000,000.
Since some nonionic water-soluble polymers become cationic in a strong acid solution having a pH of 1 or less, the pH of polishing compositions may need to be increased above that level. The pH of polishing compositions is preferably within the range of 5 to 11, more preferably within the range of 7 to 11, and still more preferably within the range of 8 to 11.

In addition, regarding the nonionic water-soluble polymers, it is preferable to use a polymer which can be dissolved in an amount of 5% by mass or more in water at 25°C.
Moreover, the hydrophilic group of the nonionic water-soluble polymers is preferably an alcoholic hydroxyl group or an amide group, and more preferably an alcoholic hydroxyl group, a cyclic amide, or an N-alkyl substituted amide group.
Furthermore, the nonionic water-soluble polymers can be obtained as a polymer composed of monomers having the aforementioned nonionic hydroxyl group and vinyl group. Examples of such monomers include acrylamide, N-vinylacetamide, dimethylacrylamide, N-isopropylacrylamide, vinylpyrrolidone, vinylcaprolactam, acryloylmorpholine, and diacetone acrylamide. In addition, the nonionic water-soluble polymers may be a homopolymer of these monomers or a copolymer. In addition, the nonionic water-soluble polymers may be a polymer in which the aforementioned hydroxyl group is introduced by a polymer reaction, and examples thereof include a polyvinyl alcohol obtained by the saponification of vinyl acetate polymers.
Further, the nonionic water-soluble polymers may be a copolymer of hydrophobic monomers as long as it is a polymer which can be dissolved in an amount of 5% by mass or more in water at 25°C. Examples of the hydrophobic monomers include styrene and N-t-octylacrylamide.
In addition, since the water-soluble polymers having an anionic group such as polyacrylic acid do not inhibit corrosion, and the water-soluble polymers having an cationic group such as polyethyleneimine tend to impair the stability of polishing compositions when silica is used as abrasive grains, either of them are suited for use. However, the monomers having these anionic groups or cationic groups may be used by copolymerizing with the aforementioned monomers having nonionic water-soluble groups within the range where desirable properties of the polishing compositions are not impaired.
Of these, examples of the monomers having anionic groups include acrylic acid, methacrylic acid, maleic acid, itaconic acid, and a salt thereof. Meanwhile, examples of the monomers having cationic groups include allylamine, N,N-dimethylaminopropylacrylamide, vinylimidazole, and a salt thereof. It should be noted that the salt also includes a quaternary salt.
Further, the content of the repeating units originated from the monomers having anionic groups or the repeating units originated from the monomers having cationic groups within a polymer is usually no more than 10% by mass and preferably no more than 5% by mass, although the content cannot be specified uniformly since it depends on the added amount of polymers in the polishing compositions. By introducing these anionic groups or cationic groups, the water-solubility of polymers can be enhanced.

Regarding the monomers having the nonionic water-soluble groups, monomers having the anionic groups, and monomers having the cationic groups described above, it is preferable to use a monomer having no ester bond. This is because ester bonds which are readily hydrolyzed may impair the stability of polishing compositions, since the polymers obtained from these monomers are added to a water-based polishing composition.
Radical polymerization in an aqueous solution or an organic solvent is generally employed since it is simple and easy, although other known methods can be employed for the polymerization. The radical polymerization is a method in which a monomer is dissolved in a solvent, and a radical initiator such as azobisisobutyronitrile is used for polymerization. During this process, the molecular weight may be adjusted by using a chain transfer agent such as dodecyl mercaptan, trimethylolpropane tris(3-mercaptopropionate), and α-methylstyrene dimer.

Among the compounds (E), 2-pyrrolidone, N-methylpyrrolidone, 1,3-dimethyl-2-imidazolidinone, gramine, adenine, N,N'-diisopropylethylenediamine, N,N'-bis(2-hydroxyethyl)ethylenediamine, N,N'-dibenzylethylenediamine, and N,N'-diphenylethylenediamine may be used alone, or two or more thereof may be combined for use.
Corrosion can be suppressed due to the use of these compounds.

### <(F) Abrasive material>

The polishing composition of the present invention may further contain an abrasive material in order to enhance the polishing rate of wiring metals or to reduce the residual metal film on the barrier film.
Examples of the abrasive materials include silica, alumina, ceria, and an organic abrasive material. In addition, these abrasive materials can be used alone, or two or more thereof can be combined for use. Although damage such as scratches may occur on the substrate surface depending on the types of abrasive materials used, it is preferable to use silica since it can reduce the level of damage while providing a satisfactory polishing rate. Moreover, it is more preferable to use an abrasive material that has colloidal silica produced by the hydrolysis of alkoxysilane or water glass as its major component.
The concentration of the abrasive material is no more than 30% by mass based on the total polishing composition, preferably within the range of 0.01 to 30% by mass, more preferably within the range of 0.1 to 20% by mass, and still more preferably within the range of 0.2 to 10% by mass. When the concentration of the abrasive material is higher than the above range, it may cause a dishing phenomenon or scratches, and thus is not preferable.
In addition, as for the size of the abrasive materials, the particle size is preferably no more than 1 µm, and more preferably within the range of 0.01 to 0.5 µm. When the particle size of the abrasive materials is below the above range, satisfactory polishing rate may not be achieved, whereas when the particle size of the abrasive materials is above large as compared to the above range, it may cause damages such as scratches on the metal surface.

### <(G) Phosphate ester having an alkyl group of 8 or more carbon atoms>

The polishing composition of the present invention may further contain a phosphate ester having an alkyl group of 8 or more carbon atoms in order to further enhance the surface planarity.
Examples of the phosphate esters include an alkyl phosphate ester such as octyl phosphate, decyl phosphate, lauryl phosphate, myristyl phosphate, cetyl phosphate, stearyl phosphate, secondary alkyl (average number of carbon atoms: 13) phosphate, 2-ethylhexyl phosphate, and oleyl phosphate; and a polyoxyalkylene ether alkyl phosphate ester such as monostearyl glyceryl ether phosphate, monocetyl glyceryl ether phosphate, monooleyl glyceryl ether phosphate, isostearyl glyceryl ether phosphate, polyoxyethylene octyl ether phosphate, polyoxyethylene decyl ether phosphate, polyoxyethylene lauryl ether phosphate, polyoxyethylene myristyl ether phosphate, polyoxyethylene cetyl ether phosphate, polyoxyethylene stearyl ether phosphate, polyoxyethylene secondary alkyl (average number of carbon atoms: 13) ether phosphate, polyoxyethylene 2-ethylhexyl ether phosphate, polyoxyethylene 2-oleyl ether phosphate, and polyoxyethylene nonylphenyl ether phosphate. In addition, it is possible to use the phosphate esters in the form of a salt such as a potassium salt and an ammonium salt. Moreover, the phosphate esters may be a primary, secondary, or tertiary ester, or a mixture thereof.
Among these, it is preferable to use an alkyl phosphate ester having 8 to 18 carbon atoms, such as octyl phosphate, lauryl phosphate and stearyl phosphate; and a polyoxyalkylene ether alkyl phosphate ester such as polyoxyethylene lauryl ether phosphate and polyoxyethylene secondary alkyl (average number of carbon atoms: 13) ether phosphate, and more preferably a polyoxyalkylene ether alkyl phosphate ester having 10 to 15 carbon atoms.
In addition, these phosphate esters having an alkyl group of 8 or more carbon atoms can be used alone, or two or more thereof can be combined for use.
It is preferable that the concentration of the phosphate ester having an alkyl group of 8 or more carbon atoms be no more than 5% by mass based on the total polishing composition, more preferably no more than 1% by mass, and still more preferably no more than 0.5% by mass. When the concentration of the phosphate ester having an alkyl group of 8 or more carbon atoms is higher than the above range, although the level of dishing phenomenon may be reduced, in view of practical performance, the polishing composition is difficult to be used in a field where a high polishing rate is required.

### <(H) Azole group-containing compound having 3 or more azole groups within a molecule>

The polishing composition of the present invention may further contain an azole group-containing compound that has 3 or more azole groups within a molecule in order to further enhance the surface planarity.
This azole group-containing compound can be produced by various methods. The azole includes imidazole, triazole, tetrazole and thiazole, and some of them may have a reactive substituent such as a hydroxyl group, a carboxyl group and an amino group. Specific examples thereof include 4-carboxyl-1H-benzotriazole, 4-hydroxybenzotriazole, and 2-aminoimidazole. Of the reactive substituents, the carboxyl group reacts with a polyhydric alcohol or a polyvalent amine to produce an ester or an amide, respectively. In this reaction process, by using a trivalent compound or a compound with a higher valency as the polyhydric alcohol or polyvalent amine, an azole group-containing compound having 3 or more azole groups within the molecule can be produced. Similarly, the azole group-containing compound having 3 or more azole groups within the molecule can also be produced by reacting an azole having a hydroxyl group or an amino group with a compound having a moiety which reacts with such a substituent.
In addition, the azole group-containing compound used in the present invention can also be produced by polymerizing an azole having a vinyl group. Examples of the azole having a vinyl group include 1-vinylimidazole and 2-[3-(2H-benzotriazol-1-yl)-4-hydroxyphenyl]ethyl methacrylate.
Among these azole group-containing compounds, it is preferable to use a polymer containing an azole unit having a vinyl group. This polymer can be obtained by polymerizing a monomer which is an azole having a vinyl group. This monomer may be polymerized alone or may be copolymerized with another monomer. Specifically, it is preferable that the azole group-containing compound is synthesized so that the molecular weight per one azole group of the azole group-containing compound is within the range of 90 to 300, particularly desirably within the range of 90 to 200.
Examples of the monomers which can be copolymerized with the azole having a vinyl group include acrylic acid, methacrylic acid, methyl acrylate, methyl methacrylate, acrylamide, N-vinylacetamide, N-vinylformamide, acryloylmorpholine, N-vinylpyrrolidone, vinyl acetate and styrene.
Radical polymerization in an aqueous solution or an organic solvent is generally employed since it is simple and easy, although other known methods can be employed for the polymerization. The radical polymerization is a method in which a monomer is dissolved in a solvent, and a radical initiator such as azobisisobutyronitrile is used for polymerization. During this process, the molecular weight may be adjusted by using a chain transfer agent such as dodecyl mercaptan, trimethylolpropane tris(3-mercaptopropionate), and α-methylstyrene dimer.
The molecular weight of the polymerization is preferably within the range of 300 to 15,000 in terms of mass average molecular weight, more preferably within the range of 500 to 10,000, still more preferably within the range of 2,000 to 8,000, and most preferably within the range of 4,500 to 6,500.
It is preferable that the concentration of the azole group-containing compound be no more than 1% by mass, more preferably within the range of 0.002 to 0.5% by mass, and still more preferably within the range of 0.003 to 0.1 % by mass. When the concentration of the compound is higher than the above range, it may impair the stability of polishing compositions.
In addition, when the azole group-containing compound is added, the low pH of polishing compositions may impair the stability of the polishing compositions. For this reason, the pH is preferably within the range of 7 to 11, and more preferably within the range of 8 to 11.

### <(I) Alkali>

The polishing composition of the present invention may further contain an alkali within the range where desirable performance and physical properties of the polishing compositions are not adversely affected.
The alkali is used for the sake of maintaining the stable polishing performance or used as a pH adjusting agent or a buffering agent. Examples of the alkali include ammonia; sodium hydroxide; potassium hydroxide; potassium carbonate; potassium bicarbonate; ammonium bicarbonate; an alkyl monoamine such as methylamine, ethylamine, propylamine, isopropylamine, butylamine, isobutylamine, t-butylamine, amylamine, allylamine, 2-ethylhexylamine, cyclohexylamine, benzylamine and furfurylamine; a hydroxyl group-containing monoamine such as O-aminophenol, ethanolamine, 3-amino-1-propanol and 2-amino-1-propanol; a diamine such as ethylenediamine, diethylenetriamine, triethylenetetramine, tetraethylenepentamine, pentaethylenehexamine, O-phenylenediamine, trimethylenediamine, 2,2-diamino-di-n-propylamine, 2-methyl-2-(2-benzylthioethyl)ethylenediamine, 1,5-diamino-3-pentanol, 1,3-diamino-2-propanol, xylenediamine, and bisaminopropylpolyalkylene ether. In addition, such alkali can be used alone, or two or more thereof can be combined for use. Among them, it is preferable to use ammonia or potassium hydroxide. It is preferable that the concentration of the alkali be no more than 10% by mass based on the total polishing composition, more preferably no more than 5% by mass, and still more preferably no more than 1 % by mass.

### <(J) Benzotriazole, tolyltriazole, hydroxybenzotriazole, carboxybenzotriazole, benzimidazole, tetrazole, quinaldic acid>

The polishing composition of the present invention can further reduce the level of corrosion on the wiring metal surface by containing an anticorrosive.
Examples of the anticorrosive include benzimidazole-2-thiol, 2-[2-(benzothiazolyl)]thiopropionic acid, 2-[2-(benzothiazolyl)]thiobutyric acid, 2-mercaptobenzothiazole, 1,2,3-triazole, 1,2,4-triazole, 3-amino-1H-1,2,4-triazole, benzotriazole, 1-hydroxybenzotriazole, 1-dihydroxypropylbenzotriazole, 2,3-dicarboxypropylbenzotriazole, 4-hydroxybenzotriazole, 4-carboxyl-1H-benzotriazole, 4-methoxycarbonyl-1H-benzotriazole, 4-butoxycarbonyl-1H-benzotriazole, 4-octyloxycarbonyl-1H-benzotriazole, 5-hexylbenzotriazole, N-(1,2,3-benzotriazolyl-1-methyl)-N-(1,2,4-triazolyl-1-methyl)-2-ethylhexylamine, tolyltriazole, naphthotriazole, bis[(1-benzotriazolyl)methyl]phosphonic acid, benzimidazole, and tetrazole; or a salt thereof. Among them, it is preferable to use benzotriazole, tolyltriazole, hydroxybenzotriazole, carboxybenzotriazole, benzimidazole, tetrazole, or quinaldic acid.
In addition, since these anticorrosives are capable of considerably suppressing the polishing rate of wiring metals, it is preferable that these anticorrosives be added in the minimum amount necessary. In other words, it is preferable that the concentration of the anticorrosive be no more than 1% by mass based on the total polishing composition, more preferably no more than 0.5% by mass, and still more preferably no more than 0.01 % by mass.

### (Use of polishing composition)

### <pH>

The polishing composition of the present invention is preferably used at a pH within the range of 2 to 12, more preferably within the range of 3 to 11, and still more preferably within the range of 5 to 11. As for the reagent for adjusting the pH to such a range, the inorganic acid, the organic acid or the alkali described above can be used.

### (Polishing apparatus)

A polishing method using the polishing composition of the present invention is a method to polish a metal film, which is a subject to be polished, by supplying the polishing composition of the present invention onto a polishing cloth of the polishing platen, and while pressing a substrate having a metal film thereon against the polishing cloth, causing relative movement between the polishing platen and the substrate in an in-plane direction.
In this polishing method, a common polishing apparatus can be used which is equipped with a holder for holding a semiconductor substrate and a platen where a polishing cloth is attached.
The rotation speed of the polishing platen greatly differs depending on the structure and size of the polishing apparatus, and thus it is difficult to specify here. However, when a common polishing machine is used, the polishing is preferably performed at a rotation speed within the range of 10 to 500 m/min, more preferably within the range of 20 to 300 m/min, and still more preferably within the range of 30 to 150 m/min.
Further, although the polishing platen rotates in the polishing apparatus during the polishing process, the substrate also needs to be rotated so as to maintain the uniformity of polishing. Although the rotation speed of the substrate is almost the same as that of the polishing platen, the rotation speed of the polishing platen is sometimes lowered or raised for achieving the uniformity of polishing. In addition, the substrate is pressed against the polishing cloth by applying a pressure through the holder, and the pressure during this process is preferably within the range of 0.1 to 100 kPa. Polishing needs to be conducted at a low polishing pressure in recent years, and the polishing composition of the present invention is capable of providing practical polishing rate during the polishing process even at a low polishing pressure. In the present invention, the polishing can be conducted preferably at a polishing pressure within the range of 0.6 to 35 kPa, more preferably within the range of 0.6 to 20 kPa. Moreover, these polishing conditions can be changed in the midst of polishing process, and, for example, the rotation speed may be raised during one half of the polishing period and lowered in the other half.

### <Polishing cloth>

Regarding the polishing cloth, for example, a common nonwoven fabric or polyurethane foam can be used. Many of the polishing cloths are provided with a groove for the sake of increasing the polishing rate or achieving smooth discharge of a slurry. Examples thereof include those with a groove in the lengthwise and widthwise directions (XY groove), those with a concentric groove (K groove), and those having the combination of these grooves. In the present invention, any of these polishing cloths can be used. Moreover, the polishing cloth can be dressed by a dresser with a diamond or the like so as to prevent clogging and conduct stable polishing, and a commonly known dressing method may also be used in this case.

### <Temperature>

It is preferable supply the polishing composition of the present invention to the polishing apparatus at a temperature close to room temperature since the temperature adjustment (of the apparatus) is not required generally. Meanwhile, it is also possible to supply the polishing composition of the present invention to the polishing apparatus after adjusting the temperature of the polishing composition for the sake of controlling the polishing rate and like. In this case, the polishing composition of the present invention is preferably supplied at a temperature within the range of 0 to 100°C, more preferably within the range of 10 to 50°C, and still more preferably within the range of 15 to 40°C. When the temperature is too low, the polishing rate does not increase, and the polishing composition may freeze at a temperature lower than 0°C. On the other hand, when the temperature is too high, unfavorable side-effects may occur.

### <Flow rate>

The amount of the polishing composition of the present invention added dropwise to a polishing apparatus is determined depending on the types of polishing apparatus and size of the wafer. In the case where an 8-inch wafer (200-mm wafer) is used, the polishing composition may be added at a rate within the range of 10 to 1,000 ml/min, preferably within the range of 50 to 500 ml/min, and more preferably within the range of 50 to 300 ml/min. The flow rate can be changed in the midst of polishing process, and, for example, the flow rate may be raised during one half of the polishing period and lowered in the other half.

### <Method for supplying polishing compositions>

Regarding the method for supplying the polishing composition of the present invention onto the polishing cloth of the polishing platen, the polishing composition is continuously supplied by use of a pump or the like. In this process, the polishing composition may be supplied as one solution containing all components, or may be supplied as several separate solutions considering the solution stability. For example, a solution containing hydrogen peroxide and a solution containing other components may be supplied separately, or a solution mainly containing abrasive grains and a solution containing other components may be supplied separately. Further, in the above case, two or more solutions can also be supplied by combining them into one solution immediately before they contact the polishing cloth. In such a case, a plurality of lines may be connected to a single line, or a mixing device such as a reservoir for mixing a plurality of polishing solutions may be used. Alternatively, the respective polishing solutions may be supplied through separate lines onto a polishing cloth. During this process, the flow rates of the respective solutions may be changed in the midst of the polishing process. For example, when two solutions are supplied separately, the amount of one of the solutions added dropwise may be increased during one half of the polishing period and lowered in the other half.

### (Compositions for becoming polishing compositions and assemblies thereof)

Considering handling convenience such as stability of the solution, the polishing composition of the present invention may be divided into a plurality of compositions during transportation or storage, or may be stored as a concentrated composition. For example, the polishing composition is divided into two compositions, i.e., a solution containing the oxidizing agent and a solution containing other components. Moreover, in the case of containing abrasive grains as an abrasive, the polishing composition may be divided into three kinds of compositions in total by further separating a solution mainly composed of the abrasive.
Also, the polishing composition of the present invention may be first prepared as a concentrated polishing composition, and used at the time of polishing by diluting it with water or the like to a concentration suitable for the polishing process. For example, a composition which is about 2 to 5-times more concentrated than that in use may be prepared.
The compositions divided as described above may be combined to constitute an assembly of a plurality of compositions which forms the polishing composition of the present invention when these divided compositions are mixed, and if needed, diluted.

### (Polishing method and substrate manufacturing method)

The present invention provides a polishing method planarizing, with use of the polishing composition of the present invention described above, a metal film embedded in a substrate having a recessed portion so as to cover the recessed portion, or a barrier metal film formed and embedded in a substrate having a recessed portion so as to cover the recessed portion; and a substrate manufacturing method including a step for polishing a substrate by the polishing method above.

In terms of the metal forming the metal film above, examples thereof include aluminum, copper, iron, tungsten, and an alloy of such a metal. Among them, it is preferable to use copper or a metal containing copper.
In terms of the metal forming the barrier metal film above, examples thereof include nickel, tantalum, titanium, ruthenium, a platinum group metal such as platinum, and an alloy of such a metal. Among them, it is preferable to use tantalum or tantalum nitride.
In terms of the interlayer insulating film, examples thereof include a silicon oxide film; an inorganic interlayer insulating film containing a large amount of silicon such as hydroxysilsesquioxane (HSQ) and methylsilsesquioxane (MSQ); or an organic interlayer insulating film such as a benzocyclobutene film. In addition, an interlayer insulating film with a low dielectric constant may also be used by providing the interlayer insulating films above with pores.
In terms of the polishing method, examples of the available methods include a method in which the removal of excess metal film and the removal of barrier metal film are conducted continuously by one polishing process, and a method in which the above removals are conducted by a plurality of separate polishing processes. However, the removal of excess metal film and the removal of barrier metal film are generally conducted by separate polishing processes. Although the removal of excess metal film and the removal of barrier metal film can be conducted by one polishing process when the polishing composition of the present invention is used, it is preferable to use the polishing composition only for the removal of excess metal film.

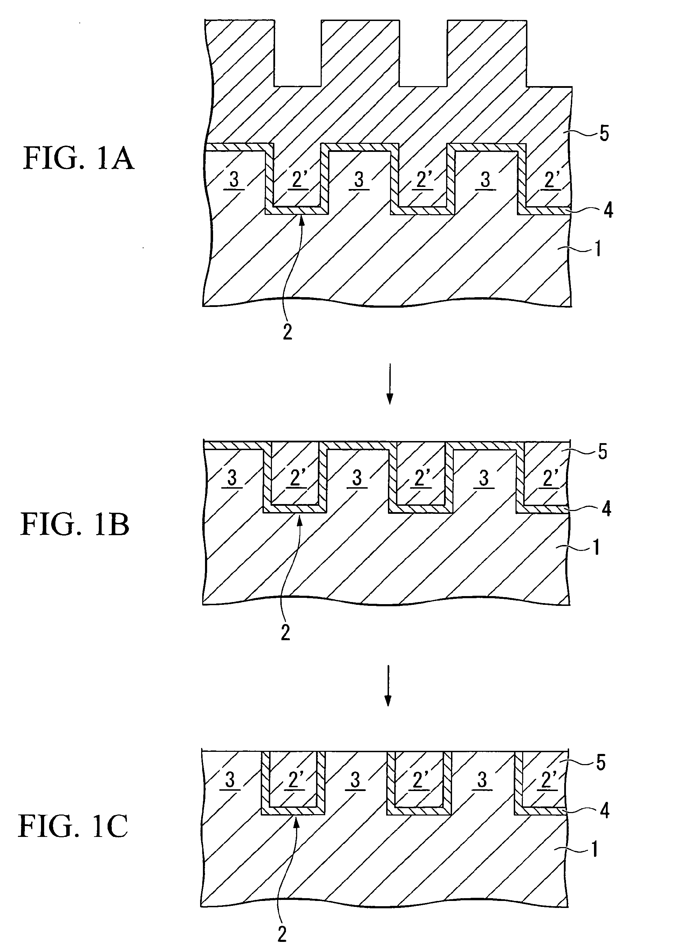

The polishing composition of the present invention can be suitably used, for example, for the wiring formation by the damascene process shown in FIG. 1. Specifically, in the wiring formation by the damascene process, a trench (recessed portion) 2 which is to become a wiring 2' is provided in an interlayer insulating film 1 in advance, and a thin barrier film 4 is formed on this interlayer insulating film 1, as shown in FIG. 1A. Then, a metal film 5 made of copper of the like is formed thereon using a film-forming method such as a plating method. During this process, since it is impossible to embed the metal film 5 only in the trench 2, it is configured so that the metal film 5 covers the entire surface of the interlayer insulating film 1 including the space 3 formed between the trenches 2. Subsequently, as shown in FIG. 1B, using the polishing composition of the present invention, the excess metal film 5 on the surface is removed by polishing, followed by the removal of the excess barrier film 4 on the surface. As a result, the surface of the interlayer insulating film 1 is exposed, as shown in FIG. 1C. Due to this process, the surface of the interlayer insulating film 1 is planarized, and the wiring 2' can be formed which is made of the metal film 5 embedded in the trenches 2.

In addition, the polishing composition of the present invention can also be suitably used for the wiring formation in MRAM. Specifically, the metal wiring used in the MRAM is formed from a conductor layer composed of aluminum or aluminum alloy, or copper or copper alloy; and a ferromagnetic layer composed of nickel-iron (Permalloy) or the like which is arranged so as to surround the conductor layer. In addition, if required, thin barrier films composed of tantalum, tantalum nitride, or the like are formed so as to sandwich the ferromagnetic layer. Since the metal wiring is formed through the damascene process described above, excess portions of the conductor layer, ferromagnetic layer, and barrier film are removed by the polishing process using the polishing composition of the present invention to provide a planarized surface.

### EXAMPLES

The present invention will be described below in more detail using Examples. However, the present invention is not limited to these Examples in any way.

### (Synthesis Example: Azole group-containing compound)

Although the Synthesis Example of an azole group-containing compound that has 3 or more azole groups will be described below, the present invention is not limited to the Synthesis Example in any way.

### <Compound A>

30 g of n-propanol were charged into a 500 ml-volume flask equipped with a thermometer, a stirring device, a nitrogen inlet tube and a reflux condenser, and were then heated to a reflux temperature of about 98°C while being stirred under a nitrogen atmosphere. Subsequently, a solution obtained by dissolving 15.72 g of 1-vinylimidazole, 74.28 g of 1-vinylpyrrolidone, and 0.066 g of 2-mercaptoethanol in 29.93 g of n-propanol (hereinafter referred to as a "monomer solution"), and a solution obtained by dissolving 0.77 g of dimethyl 2,2'-azobis(2-methylpropionate) in 215.23 g of n-propanol (hereinafter referred to as an "initiator solution 1") were respectively added thereto through a metering pump. Both solutions were added over 4 hours. After the addition of the monomer solution and initiator solution 1, the reaction was continued for another hour. Furthermore, a solution obtained by dissolving 0.77 g of dimethyl 2,2'-azobis(2-methylpropionate) in 14.63 g of n-propanol (hereinafter referred to as an "initiator solution 2") were added, and then the reaction was continued for 5 hours. The reaction solution was then cooled to room temperature, and as a result, about 380 g of a clear brown solution were obtained. An operation of concentrating this clear brown solution in a rotary vacuum evaporator and dissolving it in water was repeated twice, whereby the 2-propanol solvent was replaced with water. The solid content was 15%, and the obtained compound was directly used for the preparation of a slurry without isolation. As a result of a measurement by gel permeation chromatography (GPC), the synthesized compound A was found to have a polyethylene glycol equivalent mass average molecular weight of 5,000.

### <Compound B>

40 g of 2-propanol were charged into a 500 ml-volume flask equipped with a thermometer, a stirring device, a nitrogen inlet tube and a reflux condenser, and was then heated to a reflux temperature of about 83°C while being stirred under a nitrogen atmosphere. Subsequently, a solution obtained by dissolving 46.31 g of 1-vinylimidazole, 43.69 g of N-vinylpyrrolidone, and 1.46 g of α-methylstyrene dimer in 78 g of 2-propanol (hereinafter referred to as a "monomer solution"), and a solution obtained by dissolving 2.45 g of dimethyl 2,2'-azobis(2-methylpropionate) in 213.55 g of 2-propanol (hereinafter referred to as an "initiator solution 1") were respectively added thereto through a metering pump. The addition was carried out over 4 hours for the monomer solution and 7 hours for the initiator solution 1.
After the addition of the monomer solution and initiator solution 1, the reaction was continued for another hour. Furthermore, a solution obtained by dissolving 0.21 g of dimethyl 2,2'-azobis(2-methylpropionate) in 6.59 g of 2-propanol (hereinafter referred to as an "initiator solution 2") were added, and then the reaction was continued for 1 hour. Thereafter, the same operation of adding the initiator solution 2 followed by the continued 1-hour reaction was repeated five times, and the reaction was then continued further for 4 hours. The reaction solution was then cooled to room temperature, and as a result, about 380 g of a clear brown solution was obtained. An operation of concentrating this clear brown solution in a rotary vacuum evaporator and dissolving it in water was repeated twice, whereby the 2-propanol solvent was replaced with water. The solid content was 15%, and the obtained compound was directly used for the preparation of a slurry without isolation. As a result of a measurement by GPC, the synthesized compound was found to have a polyethylene glycol equivalent mass average molecular weight of 5,000.

### (Synthesis Example: Nonionic water-soluble polymer compound)

Although the Synthesis Example of a nonionic water-soluble polymer compound will be described below, the present invention is not limited to the Synthesis Example in any way.

### <Compound C>

55 g of n-propanol, 10 g of acryloylmorpholine, 0.36 g of dimethyl 2,2'-azobis(2-methylpropionate), and 0.08 g of 1-dodecanethiol were charged into a 100 ml-volume flask equipped with a thermometer, a stirring device, a nitrogen inlet tube and a reflux condenser, and were then heated to a reflux temperature of about 98°C while being stirred under a nitrogen atmosphere. After retaining the resultant at the refluxing temperature for 4 hours, 4.00 g of an n-propanol solution containing 4% by mass of dimethyl 2,2'-azobis(2-methylpropionate) was added, and the resulting mixture was further retained at the refluxing temperature over 4 hours. The reaction solution was then cooled to room temperature, and the obtained reaction solution was concentrated in a rotary vacuum evaporator and dissolved in water. The operation of concentration and dissolution in water was performed one more time, whereby the n-propanol solvent was replaced with water. The solid content was 5%, and the obtained compound was directly used for the preparation of a slurry without isolation. As a result of a measurement by GPC, the synthesized compound C was found to have a polyethylene glycol equivalent mass average molecular weight of 11,000.

### <Compound D>

55 g ofn-propanol, 5.15 g ofN-vinylpyrrolidone, 4.85 g ofN-isoprypylacrylamide, 0.45 g of dimethyl 2,2'-azobis(2-methylpropionate), and 0.10 g of 1-dodecanethiol were charged into a 100 ml-volume flask equipped with a thermometer, a stirring device, a nitrogen inlet tube and a reflux condenser, and were then heated to a reflux temperature of about 98°C while being stirred under a nitrogen atmosphere. After retaining the resultant at the refluxing temperature for 4 hours, 5.00 g of an n-propanol solution containing 4% by mass of dimethyl 2,2'-azobis(2-methylpropionate) were added, and the resulting mixture was further retained at the refluxing temperature over 4 hours. The reaction solution was then cooled to room temperature, and the obtained reaction solution was concentrated in a rotary vacuum evaporator and dissolved in water. The operation of concentration and dissolution in water was performed one more time, whereby the n-propanol solvent was replaced with water. The solid content was 5%, and the obtained compound was directly used for the preparation of a slurry without isolation. As a result of a measurement by GPC, the synthesized compound D was found to have a polyethylene glycol equivalent mass average molecular weight of 12,000.

### <Compound E>

55 g of n-propanol, 10 g of N-isoprypylacrylamide, 0.45 g of dimethyl 2,2'-azobis(2-methylpropionate), and 0.10 g of 1-dodecanethiol were charged into a 100 ml-volume flask equipped with a thermometer, a stirring device, a nitrogen inlet tube and a reflux condenser, and were then heated to a reflux temperature of about 98°C while being stirred under a nitrogen atmosphere. After retaining the resultant at the refluxing temperature for 4 hours, 5.00 g of an n-propanol solution containing 4% by mass of dimethyl 2,2'-azobis(2-methylpropionate) were added, and the resulting mixture was further retained at the refluxing temperature over 4 hours. The reaction solution was then cooled to room temperature, and the obtained reaction solution was concentrated in a rotary vacuum evaporator and dissolved in water. The operation of concentration and dissolution in water was performed one more time, whereby the n-propanol solvent was replaced with water. The solid content was 5%, and the obtained compound was directly used for the preparation of a slurry without isolation. As a result of a measurement by GPC, the synthesized compound E was found to have a polyethylene glycol equivalent mass average molecular weight of 4,700.

### (Wafer)

Blanket wafer: Silicon wafer uniformly coated with copper film and tantalum film (barrier film).
Patterned wafer: Silicon wafer where 500 nm-depth trenches and 25 nm-thick tantalum film as a barrier film are formed, and a copper film is coated to a thickness of 1,000 nm (refer to Fig. 1A).

### (Evaluation of polishing properties)

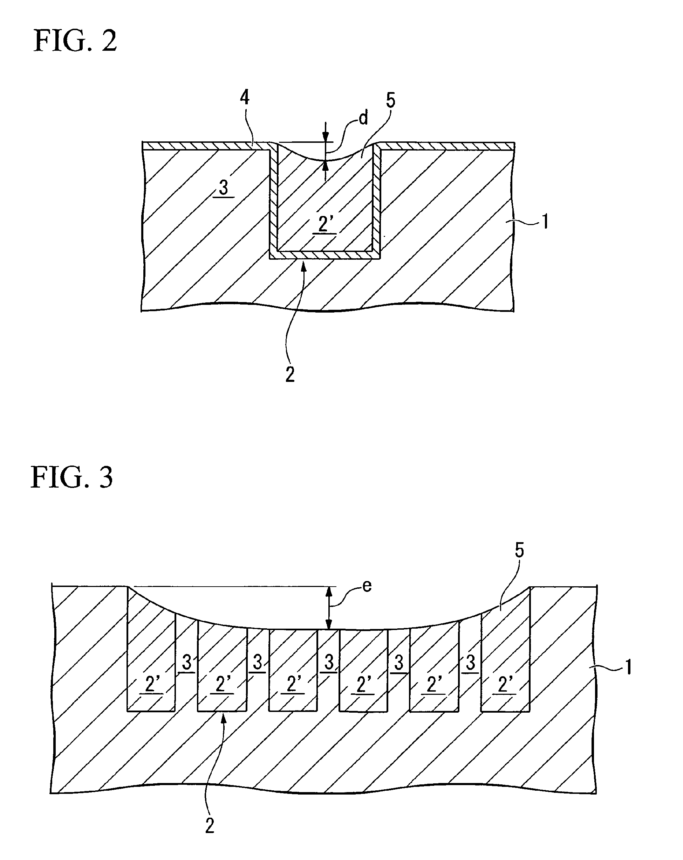

Measurement of step: A contact-type step meter was used.
Measurement of thickness of blanket copper and tantalum film: The thickness was determined based on the sheet resistance.
Measurement of polishing rate: The thickness of each of the copper film and barrier film was measured based on electrical resistance values before and after polishing, and the polishing rate was calculated on the basis of polishing time.
Polishing of patterned wafer: When a polishing machine, Mirra, manufactured by Applied Materials, Inc. was used, the endpoint was detected by an endpoint detector installed in the machine as standard equipment, and polishing was completed after 20 seconds of overpolishing process. When SH-24 manufactured by SpeedFam Co., Ltd. was used as a polishing machine, the variation in torque was adopted as the endpoint, and polishing was completed after 30 seconds of overpolishing process. When a polishing machine manufactured by Nano Factor Co., Ltd. was used, polishing was carried out, based on a polishing rate when the abovementioned patterned wafer was polished so that about 300 nm of copper remained, so as to achieve 30% of overpolish with respect to the initial copper film thickness. It should be noted that the portion of copper film measured to determine the above polishing rate was the portion with no patterns which was in the vicinity of the region where the dishing phenomenon was evaluated.
Measurement of erosion: The loss of barrier film and interlayer insulating film in the space portion of a substrate having a line/space pattern of 9 µm/1 µm (e of FIG. 3) was measured as erosion. Note that the illustration of the barrier film is omitted in FIG. 3.

### (Examples 1 to 3, Comparative Example 1)

In Examples 1 to 3 and Comparative Example 1, evaluation of an 8-inch wafer (200 mm wafer) was performed by using a polishing machine SH-24 manufactured by SpeedFam Co., Ltd. The wafer was polished at a relative speed of substrate to polishing platen of 70 m/min, a polishing composition supply rate of 150 ml/min, and a pressure of 15 kPa.
The polishing pad used in the process was IC1,400 (k groove) manufactured by Rodel Nitta Co., Ltd. The compositions of these Examples 1 to 3 and Comparative Example 1 are shown in Table 1.
It should be noted that the amount of each of the composition added which is shown in Table 1 is expressed in terms of percent by mass. In addition, the component added other than those shown in Table 1 is water. Moreover, APS denotes ammonium persulfate, DBS denotes dodecylbenzenesulfonic acid, POE denotes polyoxyethylene secondary alkyl ether phosphate ester (prepared by phosphorylating alcohol species that were composed of secondary alcohols having 13 carbon atoms on average and added with an average of 3 mol ethylene oxide), OLA denotes oleic acid, and BZI denotes benzimidazole, respectively. The colloidal silica used in this process had a particle size of 120 nm.

### [Table 1]

**[Table 1]**

| | (A) Oxidizing agent | (B) Acid | (C) Sulfonic acids having an alkyl group of 8 or more carbon atoms | (D) Fatty acids having an alkyl group of 8 or more carbon atoms | (E) | Abrasive material | Alkali | pH |
|---|---|---|---|---|---|---|---|---|
| Comparative Example 1 | APS 1.5% by mass | Oxalic acid 0.2% by mass Glycine | DBS 0.07% by mass | OLA 0.005% by mass | None | Colloidal silica 1.5% by mass | Ammonia 0.1% by mass | 8.9 |
| Example 1 | Same as above | Same as above | Same as above | Same as above | Quinolinic acid 0.3% by mass | Same as above | Ammonia 0.19% by mass | 9.0 |
| Example 2 | Same as above | Same as above | Same as above | Same as above | Picolinic acid 0.3% by mass | Same as above | Ammonia 0.1% by mass | 8.9 |
| Example 3 | Same as above | Same as above | Same as above | Same as above | Nicotinic acid 0.3% by mass | Same as above | Same as above | 9.0 |

The evaluation results for these Examples 1 to 3 and Comparative Example 1 are shown in Table 2. Note that for the evaluation of corrosion shown in Table 2, a 100 µ/100 µ square pad in the center of the wafer was observed by SEM at a magnification of 50,000, and a relative evaluation on a seven-level scale of A to G was performed; that is, the sample was rated A when corrosion was not observed in the viewing field, rated G when almost the entire region in the viewing field was corroded, and rated B, C, D, E and F as the size of the corroded portions increased.

**[Table 2]**

| | Copper Blanket polishing rate (nm/min) | Dishing (nm) | Erosion (nm) | Corrosion evaluation |
|---|---|---|---|---|
| Comp. Ex. 1 | 333 | 299 | 152 | C |
| Ex. 1 | 569 | 325 | 124 | B |
| Ex. 2 | 560 | 256 | 125 | A |
| Ex. 3 | 595 | 324 | 191 | B |

From the evaluation results shown in Table 2, it was found that Examples 1 to 3 where quinolinic acid, picolinic acid, or nicotinic acid was added had higher corrosion inhibiting effects, as compared to Comparative Example 1.

### (Examples 4 to 7, Comparative Examples 2 to 4)

In Examples 4 to 7 and Comparative Examples 2 to 4, evaluation of an 8-inch wafer was performed by using a polishing machine Mirra manufactured by Applied Materials, Inc. The wafer was polished at a relative speed of substrate to polishing platen of 75 m/min and a pressure of 14 kPa. The polishing pad used in the process was IC1,000 (k-XY groove) manufactured by Rodel Nitta Co., Ltd. The compositions of these Examples 4 to 7 and Comparative Examples 2 to 4 are shown in Table 3.
It should be noted that the amount of the component added which is shown in Table 3 is expressed in terms of percent by mass. In addition, the component added other than those shown in Table 3 is water. Moreover, APS denotes ammonium persulfate, DBS denotes dodecylbenzenesulfonic acid, POE denotes polyoxyethylene secondary alkyl ether phosphate ester, OLA denotes oleic acid, and BZI denotes benzimidazole, respectively. The colloidal silica used in this process had a particle size of 120 nm.

### [Table 3]

**[Table 3]**

| | (A) Oxidizing agent | (B) Acid | (C) Sulfonic acids having an alkyl group of 8 or more carbon atoms | (D) Fatty acids having an alkyl group of 8 or more carbon atoms | (E) | Abrasive material | Alkali | Azole group-containing compound having 3 or more azole groups within a molecule and having molecular weight of 300 to 15,000 | Phosphate ester having an alkyl group of 8 or more carbon atoms | Anticorrosive | pH |
|---|---|---|---|---|---|---|---|---|---|---|---|
| Comp. Ex. 2 | APS 1.5% by mass | Oxalic acid dihydrate 0.5% by mass | DBS 0.07% by mass | OLA 0.005% by mass | None | Colloidal silica 1.5% by mass | Ammonia | None | None | None | 8.9 |
| Ex. 4 | Same as above | Same as above | Same as above | Same as above | Picolinic acid 0.3% by mass | Same as above | Same as above | None | None | None | 9.0 |
| Comp. Ex. 3 | APS 1.5% by mass | Oxalic acid dihydrate 0.5% by mass | DBS 0.07% by mass | OLA 0.005% by mass | None | Colloidal silica 1.5% by mass | Ammonia | Compound A 0.05% by mass | None | None | 8.9 |
| Ex. 5 | Same as above | Same as above | Same as above | Same as above | Picolinic acid 0.3% by mass | Same as above | Same as above | Same as above | None | None | 9.0 |
| Ex. 6 | Same as above | Same as above | Same as above | Same as above | Picolinic acid 0.3% by mass Polyvinylpyrrolidone 0.1% by mass | Same as above | Same as above | Same as above | None | None | 9.0 |
| Comp. Ex. 4 | APS 1.5% by mass | Oxalic acid dihydrate 0.7% by mass | DBS 0.07% by mass | OLA 0.005% by mass | None | Colloidal silica 1.5% by mass | Ammonia | Compound B 0.05% by mass | POE 0.01% by mass | BZI 0.007% by mass | 9.3 |
| Ex. 7 | Same as above | Same as above | Same as above | Same as above | Picolinic acid 0.3% by mass | Same as above | Same as above | Same as above | Same as above | Same as above | 9.3 |

The evaluation results for these Examples 4 to 7 and Comparative Examples 2 to 4 are shown in Table 4. Note that the evaluation of corrosion shown in Table 4 was conducted in the same manner as that shown in Table 2.

**[Table 4]**

| | Flow rate of polishing composition (ml/min) | Copper Blanket polishing rate (nm/min) | Dishing (nm) | Erosion (nm) | Corrosion evaluation |
|---|---|---|---|---|---|
| Comp. Ex. 2 | 150 | 984 | 137 | 109 | C |
| Ex. 4 | 150 | 980 | 110 | 115 | A |
| Comp. Ex. 3 | 150 | 1019 | 73 | 63 | B |
| Ex. 5 | 150 | 1002 | 46 | 57 | A |
| Ex. 6 | 150 | 1008 | 41 | 50 | A |
| Comp. Ex. 4 | 100 | 773 | 0 | 6 | D |
| Ex. 7 | 100 | 811 | 0 | 7 | A |

From the evaluation results shown in Table 4, considerable improvements were observed in terms of corrosion in Example 4 where picolinic acid was used as compared to Comparative Example 2, although polishing rate and dishing and erosion phenomena showed little difference.
In addition, the problem of corrosion also improved in Example 5 where a vinylimidazole/vinylpyrrolidone copolymer was used as the compound having 3 or more azole groups, as compared to Comparative Example 3 where no picolinic acid was added.
As described above, in the compositions where the compound having 3 or more azole groups was added, the surface planarity observed in terms of dishing, erosion, or the like improved considerably.
In addition, also in Example 6 where vinylpyrrolidone which was a nonionic water-soluble polymer was added in addition to picolinic acid, the copper surface in which the problem of corrosion improved was observed.
Further, in Example 7, polyoxyethylene secondary alkyl ether phosphate ester was added as a surfactant, in addition to the polymer having 3 or more azole groups, and picolinic acid was also added as a non-azole anticorrosive. In this case, the problem of corrosion improved markedly as compared to Comparative Example 7 where no picolinic acid was added.

### (Examples 8 to 27, Comparative Examples 5 to 10)

A polishing machine manufactured by Nano Factor Co., Ltd. was used in Examples 8 to 27 and Comparative Examples 5 to 10. The wafer used in this process was obtained by cutting the abovementioned 8-inch wafer into 4 × 4 cm square pieces. The wafer was polished at a relative speed of substrate to polishing platen of 70 m/min, a pressure of 15 kPa, and a flow rate of polishing composition of 6.8 ml/min. The polishing pad used in the process was IC1,400 (k-XY groove) manufactured by Rodel Nitta Co., Ltd. The compositions of these Examples 8 to 27 and Comparative Examples 5 to 10 are shown in Tables 5 and 6.
It should be noted that the amount of the component added which is shown in Tables 5 and 6 is expressed in terms of percent by mass. In addition, the component added other than those shown in Tables 5 and 6 is water. Moreover, APS denotes ammonium persulfate, DBS denotes dodecylbenzenesulfonic acid, POE denotes polyoxyethylene secondary alkyl ether phosphate ester, OLA denotes oleic acid, BZI denotes benzimidazole, and PAA denotes polyacrylic acid (having an average molecular weight of 25,000 and manufactured by Wako Pure Chemical Industries, Ltd.), respectively. The colloidal silica used in this process had a particle size of 120 nm. In addition, Luvitec K17 (mass average molecular weight: 9,000), Luvitec K30 (mass average molecular weight: 45,000), and Luvitec K85 (mass average molecular weight: 900,000) denote polyvinylpyrrolidone manufactured by BASF Corporation, Luvicap EG (mass average molecular weight: 9,000) denotes polyvinylcaprolactam manufactured by BASF Corporation, PVA203 (average degree of polymerization: 300) denotes polyvinyl alcohol manufactured by Kuraray Co., Ltd., UD-350W denotes polyurethane polyol, Surfynol 465 denotes a polyether compound of acetylene-based dialcohol (manufactured by Air Products and Chemicals, Inc.), and Emulgen120 denotes polyoxyethylene (12) lauryl ether (manufactured by Kao Corporation), respectively.

### [Table 5]

**[Table 5]**

| | (A) Oxidizing agent | (B) Acid | (C) Sulfonic acids having an alkyl group of 8 or more carbon atoms | (D) Fatty acids having an alkyl group of 8 or more carbon atoms | (E) | Abrasive material | Alkali | Anticorrosive | Other components | pH |
|---|---|---|---|---|---|---|---|---|---|---|
| Comp. Ex. 5 | APS 1.5% by mass | Oxalic acid dihydrate 0.7% by mass | DBS 0.07% by mass | OLA 0.005% by mass | None | Colloidal silica 1.5% by mass | Ammonia 0.32% by mass | None | None | 9.3 |
| Ex. 8 | Same as above | Same as above | Same as above | Same as above | Luvitec K17 0.1% by mass | Same as above | Same as above | None | None | 9.0 |
| Ex. 9 | Same as above | Same as above | Same as above | Same as above | Luvitec K30 0.1% by mass | Same as above | Same as above | None | None | 8.9 |
| Ex. 10 | Same as above | Same as above | Same as above | Same as above | Luvitec K85CQ 0.1% by mass | Same as above | Same as above | None | None | 9.0 |
| Ex. 11 | Same as above | Same as above | Same as above | Same as above | Luvicap EG 0.1% by mass | Same as above | Same as above | None | None | 9.0 |
| Ex. 12 | Same as above | Same as above | Same as above | Same as above | PVA203 0.1% by mass | Same as above | Same as above | BZI 0.007% by mass | None | 9.3 |
| Ex. 13 | Same as above | Same as above | Same as above | Same as above | UD-350W 0.3% by mass | Same as above | Same as above | BZI 0.007% by mass | None | 9.3 |
| Ex. 14 | Same as above | Same as above | Same as above | Same as above | Compound C 0.1% by mass | Same as above | Same as above | None | None | 9.0 |
| Ex. 15 | Same as above | Same as above | Same as above | Same as above | Compound D 0.1% by mass | Same as above | Same as above | None | None | 8.9 |
| Ex. 16 | Same as above | Same as above | Same as above | Same as above | Compound E 0.1% by mass | Same as above | Same as above | None | None | 9.0 |
| Ex. 17 | Same as above | Same as above | DBS 0.07% by mass | OLA 0.03% by mass | Luvitec K17 0.1% by mass | Same as above | Same as above | None | None | 9.0 |
| Ex. 18 | Same as above | Same as above | Same as above | Same as above | Compound C 0.1% by mass | Same as above | Same as above | None | None | 9.3 |

### [Table 6]

**[Table 6]**

| | (A) Oxidizing agent | (B) Acid | (C) Sulfonic acids having an alkyl goup of 8 or more carbon atoms | (D) Fatty acids having an alkyl group of 8 or more carbon atoms | (E) | Abrasive material | Alkali | Anticorrosive | Other components | pH |
|---|---|---|---|---|---|---|---|---|---|---|
| Ex. 19 | Same as above | Same as above | Same as above | Same as above | Compound D 0.3% by mass | Same as above | Same as above | None | None | 9.3 |
| Ex. 20 | Same as above | Same as above | DBS 0.07% by mass | OLA 0.005% by mass | 2-pyrrolidone 1% by mass | Same as above | Same as above | None | None | 9.3 |
| Ex. 21 | Same as above | Same as above | Same as above | Same as above | N-methylpyrrolidone 1% by mass | Same as above | Same as above | None | None | 9.4 |
| Ex. 22 | Same as above | Same as above | Same as above | Same as above | 1,3-dimethyl-2-imidazolidinone 0.5% by mass | Same as above | Same as above | None | None | 9.5 |
| Ex. 23 | Same as above | Same as above | Same as above | Same as above | Gramine 0.01% by mass | Same as above | Same as above | None | None | 9.1 |
| Ex. 24 | Same as above | Same as above | Same as above | Same as above | Adenine 0.01% by mass | Same as above | Same as above | BZI 0.007% by mass | None | 9.1 |
| Ex. 25 | Same as above | Same as above | Same as above | Same as above | N,N'-diisopropylethylenediami ne 0.05% by mass | Same as above | Same as above | BZI 0.007% by mass | None | 9.3 |
| Ex. 26 | Same as above | Same as above | Same as above | Same as above | N,N'-bis(2-hydroxyethyl)ethyle nediamine 0.05% by mass | Same as above | Same as above | None | None | 9.3 |
| Ex. 27 | Same as above | Same as above | Same as above | Same as above | N,N'-dibenzylethylenediamine 0.05% by mass | Same as above | Same as above | None | None | 9.3 |
| Comp. Ex. 6 | Same as above | Same as above | Same as above | Same as above | None | Same as above | Same as above | None | PAA 0.1% by mass Sodium | 8.9 |
| Comp. Ex. 7 | Same as above | Same as above | Same as above | Same as above | None | Same as above | Same as above | None | alginate 0.1% by mass | 9.0 |
| Comp. | APS 1.0w% | None | None | None | None | Same as above | KOH 0.37% by | Quinaldic | Surfynol 465 | 9.5 |
| Ex. 8 | | | | | | | mass | acid 0.5% by mass | 0.05% by mass | |
| Comp. Ex. 9 | Same as above | None | DBS 0.05% by mass | None | None | Colloidal silica 1.0% by mass | Ammonia 0.16% by mass | Quinaldic acid 0.5% by mass | Emulgen 120 0.025% by mass | 9.2 |
| Comp. Ex. 10 | Hydrogen peroxide 1.5% by mass | Glycine 0.9% by mass | None | None | None | Colloidal silica 5.3% by mass | None | BTA 0.012% by mass | None | 6.8 |

The evaluation results for these Examples 8 to 27 and Comparative Examples 5 to 10 are shown in Table 7. Note that the evaluation of corrosion shown in Table 7 was conducted in the same manner as that shown in Table 2.

**[Table 7]**

| | Copper Blanket polishing rate (nm/min) | Dishing (nm) | Erosion (nm) | Corrosion evaluation |
|---|---|---|---|---|
| Comp. Ex. 5 | 935 | 211 | 13 | D |
| Ex. 8 | 1068 | 170 | 6 | A |
| Ex. 9 | 1038 | 85 | 4 | A |
| Ex. 10 | 1224 | 95 | 12 | A |
| Ex. 11 | 941 | 217 | 9 | B |
| Ex. 12 | 848 | 179 | 10 | B |
| Ex. 13 | 797 | 205 | 11 | B |
| Ex. 14 | 902 | 102 | 5 | B |
| Ex. 15 | 896 | 71 | 1 | A |
| Ex. 16 | 1019 | 82 | 3 | B |
| Ex. 17 | 781 | 72 | 5 | A |
| Ex. 18 | 807 | 52 | 6 | A |
| Ex. 19 | 631 | 21 | 2 | A |
| Ex. 20 | 798 | 178 | 17 | A |
| Ex. 21 | 747 | 195 | 30 | B |
| Ex. 22 | 620 | 209 | 202 | B |
| Ex. 23 | 852 | 227 | 22 | A |
| Ex. 24 | 771 | 218 | 14 | B |
| Ex. 25 | 872 | 207 | 21 | B |
| Ex. 26 | 752 | 191 | 14 | B |
| Ex. 27 | 1028 | 273 | 34 | B |
| Comp. Ex. 6 | 879 | 465 | 30 | G |
| Comp. Ex. 7 | 1042 | 330 | 92 | F |
| Comp. Ex. 8 | 324 | 174 | 76 | D |
| Comp. Ex. 9 | 278 | 60 | 18 | D |
| Comp. Ex. 10 | 587 | 241 | 117 | E |

Examples 8 to 19 shown in Table 7 are working Examples where nonionic water-soluble polymers are used. Polyvinylpyrrolidone, polyvinylcaprolactam, polyvinyl alcohol, polyurethane polyol, polyacryloylmorpholine (compound C), a polyvinylpyrrolidone/isopropylacrylamide copolymer (compound D), and polyisopropylacrylamide (compound E) were used. Compared to Comparative Example 5, although some cases showed little difference or even deterioration in terms of dishing phenomena, corrosion was inhibited considerably in all the cases where nonionic water-soluble polymers were used.
In addition, in terms of polishing rate, most Examples showed comparable rates to those of Comparative Examples, although Example 19 showed slight decline.
In Examples 12 and 13 where benzimidazole was added as an anticorrosive, the achievement of smooth copper surface was verified.
It was verified that all of Examples 20 to 27 where 2-pyrrolidone, N-methylpyrrolidone, 1,3-dimethyl-2-imidazolidinone, gramine, adenine, N,N'-diisopropylethylenediamine, N,N'-bis(2-hydroxyethylenediamine), or N,N'-dibenzylethylenediamine was used had higher corrosion inhibiting effects, as compared to Comparative Example 5.
It was possible to inhibit corrosion in these Examples without deterioration in terms of the dishing phenomenon.
In Example 27, the addition of N,N'-dibenzylethylenediamine achieved inhibition of corrosion, although the extent of dishing increased. In Comparative Examples 6 and 7 where an anionic water-soluble polymer was added to the composition of Comparative Example 5, not only the extent of dishing increased but also the overall corrosion progressed.
In Comparative Examples 8 and 9, the state of the copper surface in terms of corrosion deteriorated and the polishing rate was also low, although the extent of dishing was improved. In Comparative Example 10, the state of the copper surface in terms of corrosion deteriorated considerably when 0.9 wt.% of glycine was added in order to secure the polishing rate, even though BTA which had high anticorrosive effects with respect to copper was used.

### INDUSTRIAL APPLICABILITY

The present invention can be applied to a polishing composition that is suitably used for polishing a metal film formed on a substrate, and can also be applied to a technique regarding such polishing compositions.

## Claims

1. A polishing composition comprising:
(A) an oxidizing agent;
(B) at least one acid selected from an amino acid, a carboxylic acid of no more than 8 carbon atoms, and an inorganic acid;
(C) a sulfonic acid having a concentration of 0.01 % by mass or more and having an alkyl group of 8 or more carbon atoms;
(D) a fatty acid having a concentration of 0.001 % by mass or more and having an alkyl group of 8 or more carbon atoms; and
(E) at least one compound selected from a pyridine carbonyl compound, a nonionic water-soluble polymer, 2-pyrrolidone, N-methylpyrrolidone, 1,3-dimethyl-2-imidazolidinone, gramine, adenine, N,N'-diisopropylethylenediamine, N,N'-bis(2-hydroxyethyl)ethylenediamine, N,N'-dibenzylethylenediamine, and N,N'-diphenylethylenediamine.

2. The polishing composition according to Claim 1, wherein the oxidizing agent is a persulfate salt.

3. The polishing composition according to Claim 1 or 2, wherein a concentration of the oxidizing agent is within the range of 0.01 to 30% by mass.

4. The polishing composition according to Claim 1 or 2, wherein the carboxylic acid of no more than 8 carbon atoms is oxalic acid.

5. The polishing composition according to Claim 1 or 2, wherein the sulfonic acid having an alkyl group of 8 or more carbon atoms is alkylbenzene sulfonic acid.

6. The polishing composition according to Claim 1 or 2, wherein the fatty acid having an alkyl group of 8 or more carbon atoms is oleic acid.

7. The polishing composition according to Claim 1 or 2, wherein the pyridine carbonyl compound is picolinic acid or picolinamide.

8. The polishing composition according to Claim 1 or 2, wherein the nonionic water-soluble polymer is at least one selected from a polyvinyl alcohol, a vinylpyrrolidone (co)polymer, an acryloylmorpholine (co)polymer, and an N-isopropylacrylamide (co)polymer.

9. The polishing composition according to Claim 1 or 2, wherein a molecular weight of the nonionic water-soluble polymer is within the range of 3,000 to 1,000,000.

10. The polishing composition according to Claim 1 or 2, wherein a concentration of a component (E) is within the range of 0.01 to 5% by mass.

11. The polishing composition according to Claim 1 or 2, further comprising an abrasive material.

12. The polishing composition according to Claim 11, wherein a concentration of the abrasive material is no more than 30% by mass.

13. The polishing composition according to Claim 11, wherein the abrasive material is colloidal silica.

14. The polishing composition according to Claim 1 or 2, further comprising a phosphate ester having an alkyl group of 8 or more carbon atoms.

15. The polishing composition according to Claim 14, wherein a concentration of the phosphate ester having an alkyl group of 8 or more carbon atoms is no more than 0.5% by mass.

16. The polishing composition according to Claim 1 or 2, further comprising an azole group-containing compound that has 3 or more azole groups within a molecule.

17. The polishing composition according to Claim 16, wherein a molecular weight of the azole group-containing compound is within the range of 300 to 15,000.

18. The polishing composition according to Claim 16, wherein the azole group containing-compound is a polymer having an azole unit that includes a vinyl group.

19. The polishing composition according to Claim 16, wherein a concentration of the azole group-containing compound is within the range of 0.001 to 1% by mass.

20. The polishing composition according to Claim 16, wherein a molecular weight per one azole group of the azole group-containing compound is within the range of 90 to 300.

21. The polishing composition according to Claim 1 or 2, further comprising an alkali.

22. The polishing composition according to Claim 1 or 2, wherein the pH is within the range of 5 to 11.

23. The polishing composition according to Claim 16, wherein the pH is within the range of 7 to 11.

24. The polishing composition according to Claim 1 or 2, further comprising at least one compound selected from benzotriazole, tolyltriazole, hydroxybenzotriazole, carboxybenzotriazole, benzimidazole, tetrazole and quinaldic acid, wherein a concentration of the compound is no more than 0.5% by mass.

25. The polishing composition according to Claim 1 or 2, wherein the polishing composition is used for polishing a metal film embedded in a substrate having a recessed portion so as to cover the recessed portion, or for polishing a barrier metal film formed and embedded in a substrate having a recessed portion so as to cover the recessed portion.

26. A polishing method comprising
planarizing, with use of the polishing composition of Claim 1 or 2, a metal film embedded in a substrate having a recessed portion so as to cover the recessed portion, or a barrier metal film formed and embedded in a substrate having a recessed portion so as to cover the recessed portion.

27. The polishing method according to Claim 26, wherein the metal film embedded in a substrate having a recessed portion so as to cover the recessed portion is made of copper or a copper-containing alloy.

28. The polishing method according to Claim 26, wherein the barrier metal film is made of tantalum or a tantalum alloy.

29. A method for manufacturing a substrate comprising polishing a substrate by the polishing method of Claim 25.

30. A composition which becomes the polishing composition of Claim 3 when diluted with water.

31. A method for using the composition of Claim 30 as a composition for transportation or storage.

32. An assembly comprising a plurality of compositions which forms the polishing composition of Claim 1 or 2 when the compositions are mixed or mixed and diluted with water.

33. A method for using the assembly of Claim 32 as a composition for transportation or storage.
